# EUROPEAN PATENT SPECIFICATION

(11) **EP 1 754 976 B1**
(45) Date of publication and mention of the grant of the patent: **29.09.2010**
(21) Application number: 05107610.7
(22) Date of filing: 18.08.2005
(51) Int. Cl.: G01R 31/28

(54) **Test Fixture With Clamping Top Plate Using Magnetic Force**
Testhalterung mit Deckplatte zur Arretierung mittels Magnetischer Kraft
Dispositif d'essai avec plaque supérieure de fixation utilisant force magnétique

(43) Date of publication of application: 21.02.2007
(73) Proprietor: RESEARCH IN MOTION LIMITED, Waterloo, Ontario N2L 3W8 (CA)
(72) Inventor: Chang, Kyun-Jung, Waterloo, Ontario N2T 2T7 (CA); Ivannikov, Arkady, Mississauga, Ontario L4W 2S8 (CA); Reksnis, Marek, Waterloo, Ontario N2T 1L1 (CA)
(74) Representative: Patel, Binesh

(56) References cited:
- US-A- 5 572 144
- US-A- 5 831 160
- US-A1- 2002 074 993
- US-A1- 2004 226 167
- US-A1- 2004 257 097
- ANONYMOUS: "Agilent Technologies' TS-50 RF Shielded Test Fixtures" , [Online] 2000, pages 1-8, Retrieved from the Internet: URL:http://cp.literature.agilent.com/litwe b/pdf/5968-6858E.pdf> [retrieved on 2009-09-09]

## Description

An electronic component testing fixture positions and then clamps a component between a test bed platform and a manually removable clamping plate using magnetic attractive force.

The testing of electronic components or devices during manufacturing involves use of a test fixture to accurately position the device under test so that electrical contacts are properly engaged to perform the test. Inaccurate placement or lack of appropriate electrical contact could result in a false rejection of the device under test and significant waste.

For example, power contacts and control system contacts on circuit board devices are engaged with matching contacts on a test fixture by manually or mechanically placing the circuit board device on the test fixture. Guide pins or other physical barriers are located on the test bed to accurately guide and locate the device to be tested into the correct testing position.

In the in use application of a circuit board device, the electrical contacts may be soldered, or engaged with tight fitting connectors, and the circuit boards are usually snap-locked, fastened or clamped securely in a housing to avoid malfunctions or short circuits in use.

However, in a test fixture, such secure means of making electrical contacts are inefficient and would interfere with the speed of testing required during manufacture. Test fixtures therefore include temporary means of making electrical contact which minimize the risk damage to the device under test and which aim to involve minimal time in positioning and withdrawing the devices under test to increase the speed of testing.

Since many electronic devices are very light weight and flexible, merely placing the devices in a test fixture is insufficient to ensure that proper electrical contact is made. Commonly the device is physically clamped to exert pressure on the matching electric contacts and ensure that a reliable connection is made for conducting the testing procedure.

Pneumatic, hydraulic or mechanical clamping systems, including robotic systems are commonly used for this clamping function. However, all such systems require physical space in the manufacturing facility, require maintenance due to inevitable wear and tear of moving parts, and require periodic adjustments to maintain accuracy, consume power, impose operating and capital costs, and often create significant noise or safety hazards. In many cases, the test fixture and associated clamping system must be housed within a protective housing such as a radio frequency housing, a noise suppression housing, a dust proof housing, a temperature controlled housing or other protected environments. The use of mechanical, pneumatic or hydraulic clamping systems significantly increases the necessary space volume of any protective enclosure consuming manufacturing space and imposing various costs on the manufacturing process.

US5572144 discloses a test jig for probing single or double sided printed circuit boards. The test jig has a hingedly attached top cover. US2004/257097 also discloses a test fixture for testing a circuit board. It discloses a vacuum pump to actuate various plates and a diaphragm and to create a vacuum in a test chamber.

US2004/226167 discloses a screw mounting jig for installing screws during assembly of an electronic device. The jig includes a base and support assembly. The support assembly includes first and second plates. Magnets may be used to assist in securing the first and second plates to one another, but the magnets do not secure a cover to a test platform. US5831160 discloses a test fixture clamping system for holding a circuit board in a test fixture for testing. The system does not employ magnets.

Another test fixture is described in the brochure "Agilent Technologies' TS-50 RF Shielded Test Fixtures".

### DESCRIPTION OF THE DRAWINGS

In order that the subject matter may be readily understood, one embodiment of the subject matter is illustrated by way of example in the accompanying drawings.

Figure 1 is a top isometric view of one embodiment showing a test fixture with test platform with cylindrical pins as device positioning guides and at an elevated position a retention cover with manual grip handle having matching cylindrical recesses and having a cylindrical recess socket in each corner to house permanent corner.

Figure 2 is a like top isometric view showing an electronic device positioned on the electrically conductive contacts protruding from the test platform and aligned by the cylindrical pins serving as device positioning guides.

Figure 3 is a front isometric view showing the electronic device for testing position within the test platform and showing containment housing with hinged lid surrounding the entire test platform.

Figure 4 is a vertical sectional view through the housing and test platform as indicated with lines 4-4 in Figure 3.

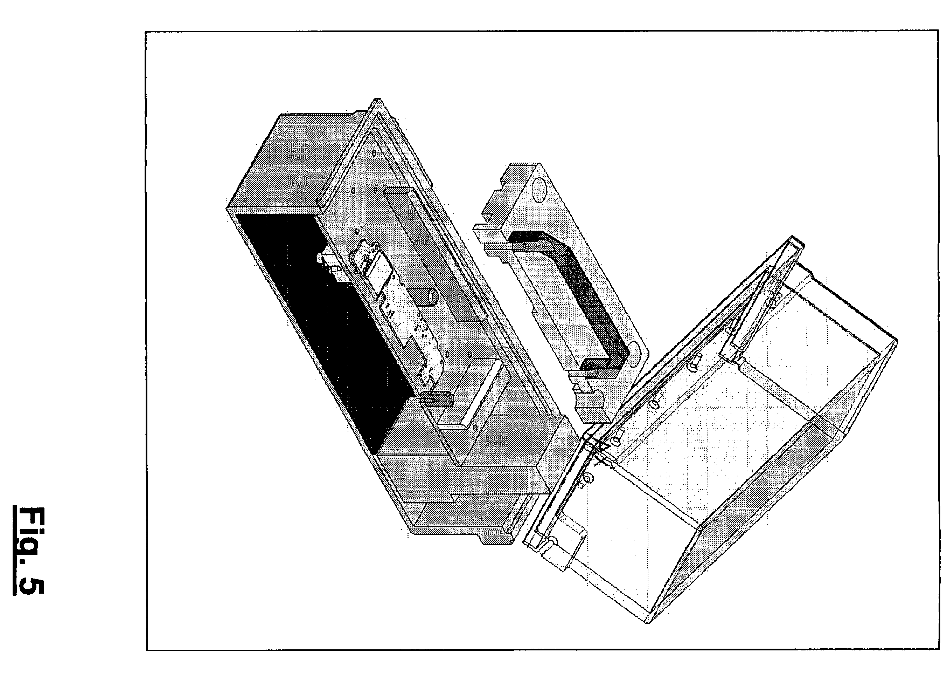

Figure 5 is an isometric view along the same section shown in Figure 4.

Figure 6 is a bottom isometric view of the test fixture showing the bottom of the test platform with electrical contacts and platform magnetic members housed beneath the platform and showing the device retention cover with a receiving socket for receiving the electronic device therein.

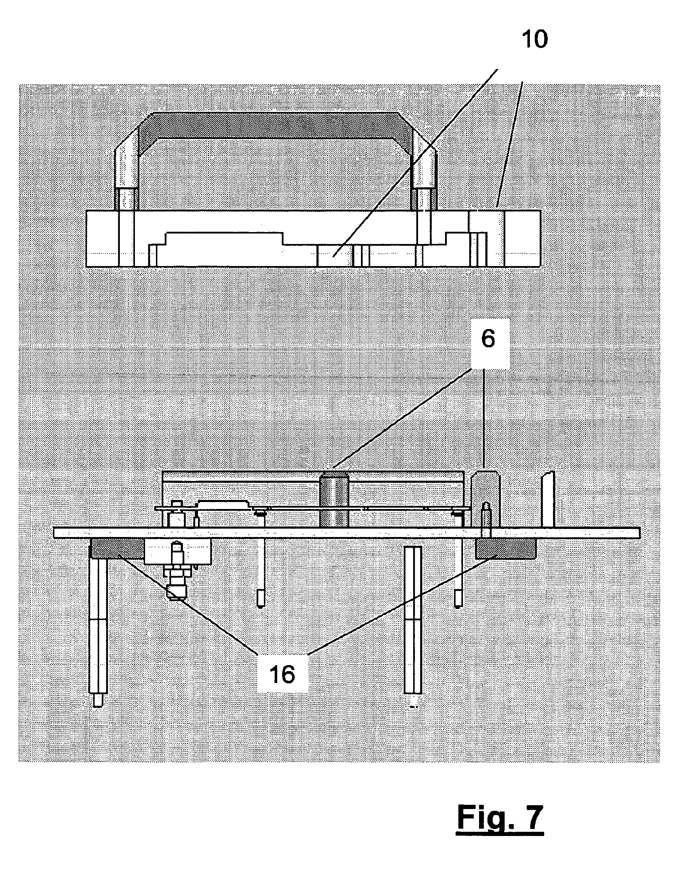

Figure 7 is a detailed sectional view along lines 7-7 of Figure 2.

Further details of the test fixture and its advantages will be apparent from the detailed description included below.

### DESCRIPTION OF PREFERRED EMBODIMENTS

There is provided a test fixture for testing an electronic device according to claim 1. It comprises: a test platform having a device receiving surface, the test platform including: electrically conductive contacts for connecting to the electronic device disposed on the a device receiving surface; at least one device positioning guide disposed on the device receiving surface; at least one platform magnetic member; a removable cover for releaseably securing to the test platform, the removable cover including at least one cover magnetic member; wherein the at least one platform magnetic member and the at least one cover magnetic member are mutually magnetically attractive.

Further, there is provided a method for producing an electronic device according to claim 16. It comprises: preparing a test fixture according to the invention for testing the electronic device; placing the electronic device using the at least one device positioning guide disposed on the device receiving surface; and placing a removable cover upon the electronic device to apply a force to the electronic device.

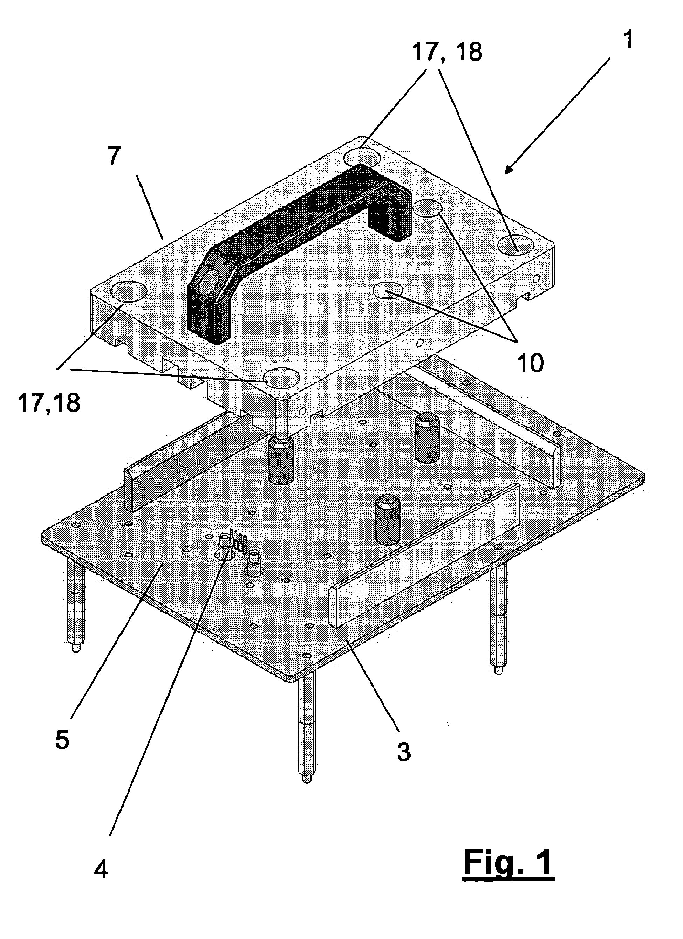

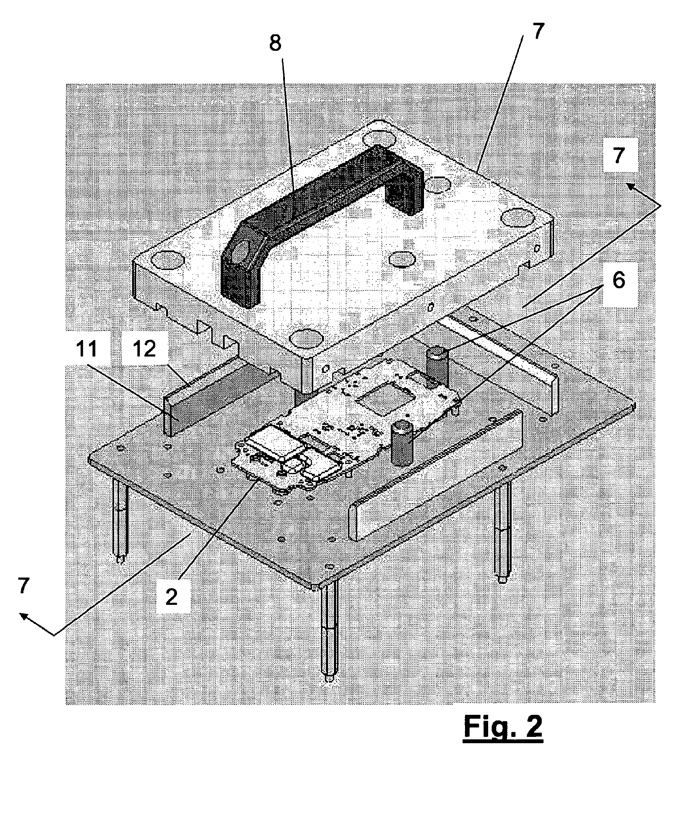

With reference to Figures 1 and 2, the test fixture 1 is provided for testing an electronic device 2 such as the illustrated circuit board for a wireless communication device.

The test fixture 1 includes a test platform 3 including electrically conducting contacts 4 (best seen in Figure 1) which protrude from a device receiving surface 5 of the test platform 3.

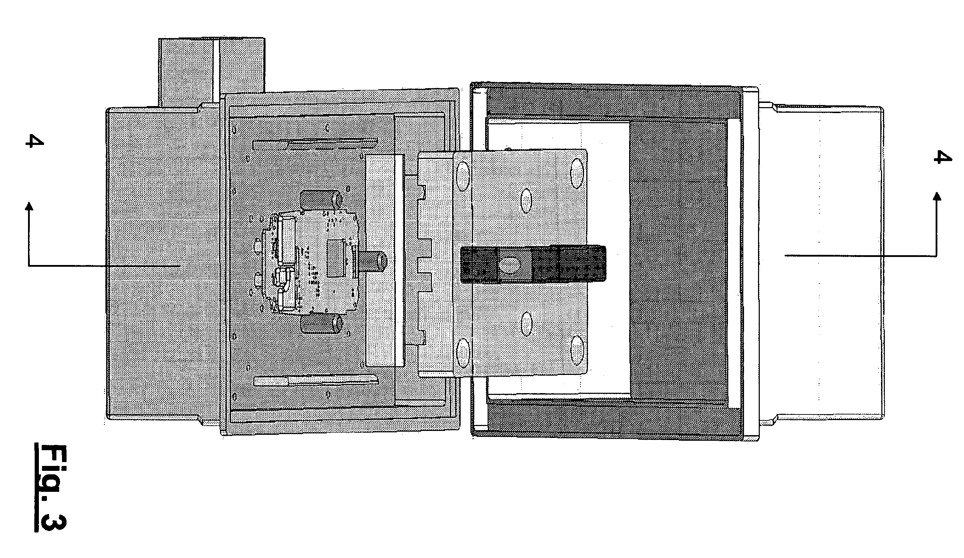

As best seen in Figures 2 and 3, the test platform 3 includes device positioning guides 6 disposed on the device receiving surface 5. In the embodiment illustrated, the device positioning guides 6 comprise cylindrical pins. However, it shall be understood that depending on the configuration of the electronic device 2, various other device positioning guides 6 can be provided such as planar members, shape conforming surfaces or rectangular protrusions for example.

It shall also be understood that the test platform 3 can be easily reconfigured for various types of electronic devices 2 by removing the cylindrical pins 6 and relocating guides to different positions to accommodate different electronic devices 2.

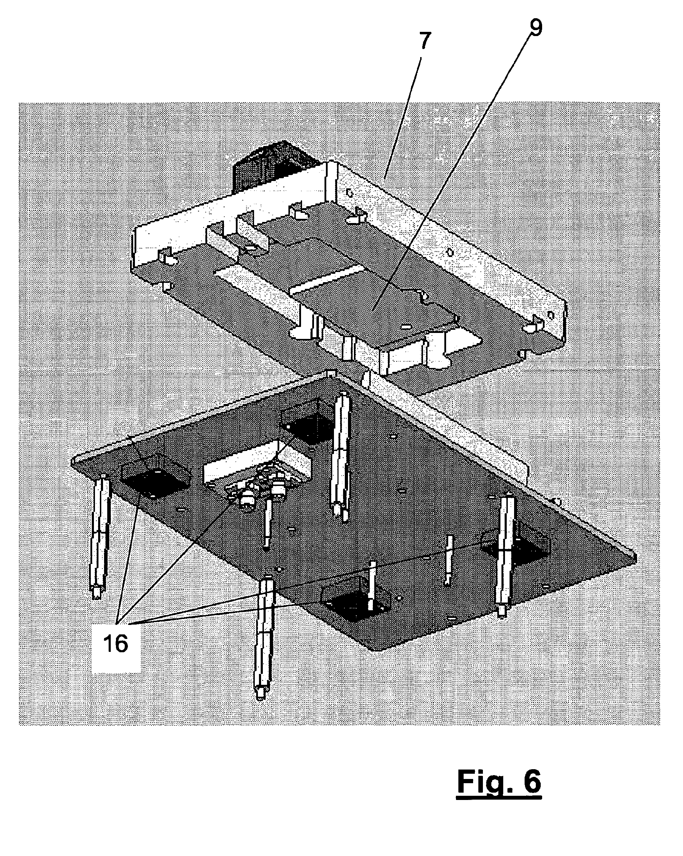

The device retention cover 7 in the embodiment shown is a simple rectangular machined plate having a manual grip 8. As best seen in Figure 6, the device retention cover 7 preferably includes a device receiving socket 9 that engages the device 2 and exerts a downward pressure to maintain adequate contact with the electrically conducting contacts 4.

The device retention cover 7 is manually positioned using cylindrical recesses 10 positioned to match the cylindrical pins 6. Further, to guide the cover 7, the test platform 3 includes three peripheral walls 11 disposed on the device receiving surface 5 each aligned with an outside edge of the retention cover 7 when the retention cover 7 is a covered position over the electronic device 2. To improve manual guiding of the cover 7, the peripheral wall 11 includes an inwardly chamfered cover guiding edge 12.

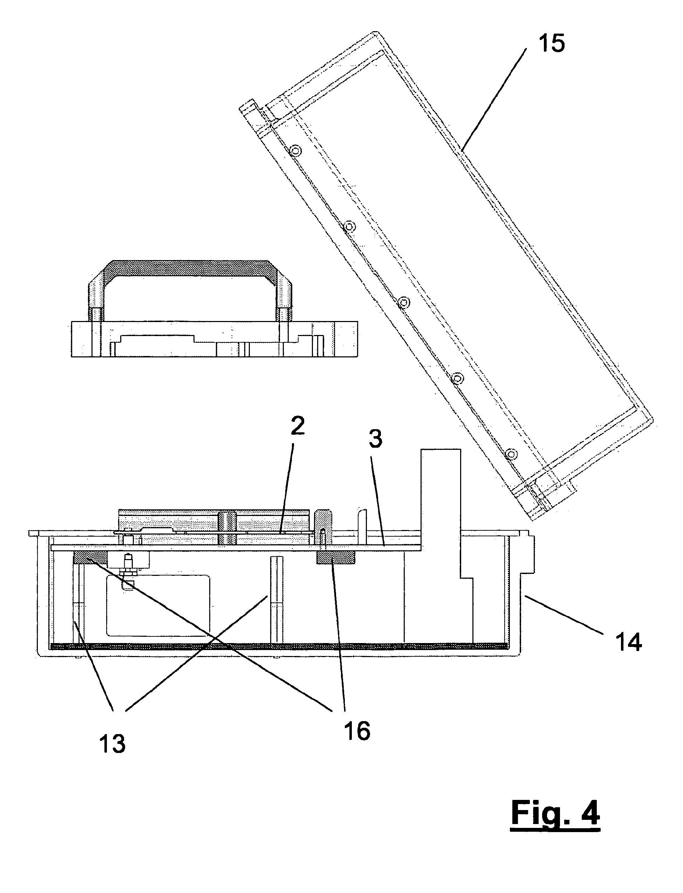

As shown in Figures 4 and 6, preferably the test platform 3 includes adjustable height removable support legs 13 and is housed within a container housing 14 with a hinged lid 15 for access. As illustrated, the support leg 13 provides adaptability to change the test fixture 1 for varying sizes of electronic devices 2 and the containment housing 14 being a simple rectangular housing with hinged lid 15 can be adapted for various sizes and shapes of electronic devices 2 for testing. In one embodiment for example, the containment housing 14 comprises a radio frequency blocking enclosure. However, other protective environments can be provided in a like manner such as noise suppression housing, a dust proof housing or a temperature control housing.

Turning to Figures 1, 4 and 6, it can be seen that the test platform 3 includes a platform magnetic member 16 as illustrated in each of the four corners. The retention cover 7 likewise includes four cover magnetic members 17 are removably housed within a recess socket 18. It will be understood that in order to exert a clamping pressure on the electronic device 2, that the platform magnetic members 16 and the cover magnetic members 17 are mutually magnetically attractive. The degree of compressive force applied by the retention cover 7 can be easily modified by selecting appropriate permanent magnets for the platform magnetic member 16 and retention cover member 17.

The platform magnetic members 16 and retention cover magnetic members 17 are preferably mutually aligned on an axis normal to the test platform 3 as illustrated in the accompanying drawings. Alignment avoids any twisting of the cover 7 relative to the test platform 3 during installation and withdrawal.

As illustrated, the components of the test fixture 1 are preferably modular in design, easily removed and replaced in various positions. The modular design results in easy modification, flexibility and relative low cost. Compared to mechanical clamping systems, pneumatic or hydraulically actuated clamping devices, the test fixture 1 is low cost and small size having only one moving part, the cover 7, that is manually positioned. Wear and tear of the fixture 1, maintenance and calibration are substantially reduced if not completely eliminated. The manual operation will alert the person performing the test to any misalignment or malfunction. As a result, safe operation is ensured, the device requires less space than mechanically operating clamping devices, and will be longer lasting requiring little maintenance while remaining simple to modify for various manufacturing applications.

## Claims

1. A test fixture (1) for testing an electronic device (2), comprising:
a test platform (3) having a device receiving surface (5), the test platform (3) including:
electrically conductive contacts (4) for connecting to the electronic device (2) disposed on the a device receiving surface (5); at least one device positioning guide (6) disposed on the device receiving surface (5);
the test fixture (1) further including a detachable device retention cover (7) for releaseably securing the electronic device to the test platform (3);
**characterized in that**
the test platform includes at least one platform magnetic member (16);
the detachable device retention cover (7) comprises at least one cover magnetic member (17);
the at least one platform magnetic member (16) and the at least one device retention cover magnetic member (17) are mutually magnetically attractive to exert clamping pressure on the electronic device (2), detachment of the at least one cover magnetic member (17) from the at least one platform magnetic member (16) detaching the device retention cover (7) from the test platform, and the device retention cover (7) is a plate having a manual grip such that the device retention cover (7) can be manually positioned and detached.

2. A test fixture (1) according to claim 1, wherein at least one of the platform magnetic member (16) and the cover magnetic member (17) comprise a permanent magnet.

3. A test fixture (1) according to claim 1 or claim 2, wherein the platform magnetic member (16) and the cover magnetic member (17) are mutually aligned on an axis normal to the test platform (3).

4. A test fixture (1) according to any one of claims 1 to 3, wherein the cover magnetic member (17) is removably housed within recessed socket (18).

5. A test fixture (1) according to any one of claims 1 to 4, wherein the at least one device positioning guide (6) comprises a cylindrical pin (6).

6. A test fixture (1) according to claim 5, wherein the detachable device retention cover (7) comprises at least one recess (10) matching the cylindrical pin (6).

7. A test fixture (1) according to any one of claims 1 to 6, wherein the test platform (3) comprises at least one cover alignment guide (11) disposed on the device receiving surface (5).

8. A test fixture (1) according to claim 7 wherein the at least one cover alignment guide (11) comprises a peripheral wall (11) aligned with an outside edge of the detachable device retention cover (7) in a covered position.

9. A test fixture (1) according to claim 8, wherein the peripheral wall (11) comprises an inwardly chamfered cover guiding edge (12).

10. A test fixture (1) according to any one of claims 1 to 9, wherein the detachable device retention cover (7) has a test platform facing surface with a device receiving socket

11. A test fixture (1) according to any one of claims 1 to 10, wherein the test platform (3) comprises support legs (13).

12. A test fixture (1) according to any one of claims 1 to 11, further comprising a containment housing (14).

13. A test fixture (1) according to claim 12, wherein the containment housing (14) comprises a radio frequency blocking enclosure.

14. A test fixture (1) according to claim 12 or claim 13, wherein the containment housing (14) has a hinged lid (15).

15. A test fixture (1) according to any one of claims 1 to 14, comprising two or more platform magnetic members (16) and two or more cover magnetic members (17), the platform magnetic members (16) and cover magnetic members (17) having a corresponding spatial arrangement for releaseably securing the detachable device retention cover (7) to the test platform (3).

16. A method of producing an electronic device, comprising:
preparing a test fixture (1) according to any one of claims 1 to 15, for testing the electronic device;
placing the electronic device (2) using the at least one device positioning guide (6) disposed on the device receiving surface (5);
the manually positioning detachable device retention cover (7) upon the electronic device (2) to exert clamping pressure on to the electronic device (2).

17. A method according to claim 16, wherein the step of placing the electronic device (2) on the device receiving surface (5) is manually performed.

18. A method according to any one of claims 16 to 17, wherein the method comprises the further step of closing a lid (15) after the step of placing the detachable device retention cover (7) upon the electronic device (2).

## Patentansprüche

1. Testvorrichtung (1) zum Testen einer elektronischen Einrichtung (2) mit einer Testplattform (3), die eine Einrichtungsaufnahmefläche (5) aufweist, wobei die Testplattform (3) folgendes aufweist:
elektrisch leitende Kontakte (4) zum Anschließen an die elektronische Einrichtung (2), die auf der Einrichtungsaufnahmefläche (5) angeordnet sind,
mindestens eine Einrichtungspositionierführung (6), die auf der Einrichtungsaufnahmefläche (5) angeordnet ist,
wobei die Vorrichtung (1) ferner einen abnehmbaren Einrichtungsfesthalte-Deckel (7) zum lösbaren Befestigen der elektronischen Einrichtung an der Testplattform (3) aufweist,
**dadurch gekennzeichnet, dass**
die Testplattform mindestens ein magnetisches Plattformelement (16) aufweist,
der abnehmbare Einrichtungsfesthalte-Deckel (7) mindestens ein magnetisches Deckelelement (17) aufweist,
das mindestens eine magnetische Plattformelement (16) und das mindestens eine magnetische Einrichtungsfesthalte-Deckelelement (17) sich gegenseitig anziehen, um auf die elektronische Einrichtung (2) Klemmdruck auszuüben, wobei das Abnehmen des mindestens einen magnetischen Deckelelements (17) von dem mindestens einen magnetischen Plattformelement (16) den Einrichtungsfesthalte-Deckel (7) von der Testplattform abnimmt und der Einrichtungsfesthalte-Deckel (7) eine Platte mit einem Handgriff ist, so dass der Einrichtungsfesthalte-Deckel (7) manuell positioniert und abgenommen werden kann.

2. Testvorrichtung (1) nach Anspruch 1, wobei mindestens eines der magnetischen Plattformelemente (16) und das magnetische Deckelelement (17) einen Permanentmagneten aufweisen.

3. Testvorrichtung (1) nach Anspruch 1 oder 2, wobei das magnetische Plattformelement (16) und das magnetische Deckelelement (17) aneinander zu einer zur Testplattform (3) normalen Achse ausgerichtet sind.

4. Testvorrichtung (1) nach einem der Ansprüche 1 bis 3, wobei das magnetische Deckelelement (17) innerhalb einer ausgesparten Fassung (18) entfernbar untergebracht ist.

5. Testvorrichtung (1) nach einem der Ansprüche 1 bis 4, wobei die mindestens eine Einrichtungspositionierführung (6) einen Zylinderstift (6) aufweist.

6. Testvorrichtung (1) nach Anspruch 5, wobei der abnehmbare Einrichtungsfesthalte-Deckel (7) mindestens eine Aussparung (10) aufweist, die dem Zylinderstift (6) entspricht.

7. Testvorrichtung (1) nach einem der Ansprüche 1 bis 6, wobei die Testplattform (3) mindestens eine Deckelausrichtungsführung (11) aufweist, die auf der Einrichtungsaufnahmefläche (5) angeordnet ist.

8. Testvorrichtung (1) nach Anspruch 7, wobei die mindestens eine Deckelausrichtungsführung (11) eine Peripherwand (11) aufweist, die in einer gedeckten Position mit einer Außenkante des abnehmbaren Einrichtungsfesthalte-Deckels (7) ausgerichtet ist.

9. Testvorrichtung (1) nach Anspruch 8, wobei die Peripherwand (11) eine einwärts abgeschrägte Deckelführungskannte (12) aufweist.

10. Testvorrichtung (1) nach einem der Ansprüche 1 bis 9, wobei der abnehmbare Einrichtungsfesthalte-Deckel (7) eine auf die Testplattform gerichtete Fläche mit einer Einrichtungsaufnahmefassung (9) aufweist.

11. Testvorrichtung (1) nach einem der Ansprüche 1 bis 10, wobei die Testplattform (3) Stützbeine (13) aufweist.

12. Testvorrichtung (1) nach einem der Ansprüche 1 bis 11 ferner mit einem Eingrenzungsgehäuse (14).

13. Testvorrichtung (1) nach Anspruch 12, wobei das Eingrenzungsgehäuse (14) eine hochfrequenzhemmende Kapselung aufweist.

14. Testvorrichtung (1) nach Anspruch 12 oder 13, wobei das Eingrenzungsgehäuse (14) einen aufklappbaren Klappdeckel (15) aufweist.

15. Testvorrichtung (1) nach einem der Ansprüche 1 bis 14 mit zwei oder mehr magnetischen Plattformelementen (16) und zwei oder mehr magnetischen Deckelelementen (17), wobei die magnetischen Plattformelemente (16) und die magnetischen Deckelelemente (17) eine entsprechende Raumanordnung zum lösbaren Befestigen des abnehmbaren Einrichtungsfesthalte-Deckels (7) an der Testplattform (3) aufweisen.

16. Verfahren zum Herstellen einer elektronischen Einrichtung, in dem:
zum Testen der elektronischen Einrichtung eine erste Testvorrichtung (1) nach einem der Ansprüche 1 bis 15 bereitgestellt wird,
die elektronische Einrichtung (2) unter Verwendung der mindestens einen Einrichtungspositionierführung (6) plaziert wird, die auf der Einrichtungsaufnahmefläche (5) angeordnet ist,
der abnehmbare Einrichtungsfesthalte-Deckel (7) auf die elektronische Einrichtung (2) positioniert wird, um auf die elektronische Einrichtung (2) Klemmdruck auszuüben.

17. Verfahren nach Anspruch 16, wobei das Plazieren der elektronischen Einrichtung (2) auf die Einrichtungsaufnahmefläche (5) von Hand ausgeführt wird.

18. Verfahren nach Anspruch 16 oder 17, wobei in dem Verfahren ferner ein Klappdeckel (15) nach dem Plazieren des abnehmbaren Einrichtungsfesthalte-Deckels (7) auf die elektronische Einrichtung (2) geschlossen wird.

## Revendications

1. Montage d'essai (1) destiné à l'essai d'un dispositif électronique (2), comprenant :
une plateforme d'essai (3) ayant une surface de réception (5) du dispositif, la plateforme d'essai (3) comportant :
des contacts électriquement conducteurs (4) à connecter au dispositif électronique (2) disposés sur la surface de réception (5) du dispositif ; au moins un guide de positionnement (6) du dispositif disposé sur la surface de réception (5) du dispositif ;
le montage d'essai (1) comportant en outre un couvercle (7) de rétention détachable du dispositif destiné à fixer de manière amovible le dispositif électronique à la plateforme d'essai (3) ; **caractérisé en ce que**
la plateforme d'essai comporte au moins un élément magnétique de plateforme (16) ;
le couvercle (7) de rétention détachable du dispositif comprend au moins un élément magnétique de couvercle (17) ;
l'au moins un élément magnétique (16) de la plateforme et l'au moins un élément magnétique (17) du couvercle de rétention du dispositif s'attirent mutuellement de manière magnétique pour exercer une pression de serrage sur le dispositif électronique (2), le détachement de l'au moins un élément magnétique (17) du couvercle de l'au moins un élément magnétique (16) de la plateforme détachant le couvercle de rétention (7) du dispositif de la plateforme d'essai, et le couvercle de rétention (7) du dispositif est une plaque ayant une poignée manuelle de sorte que le couvercle de rétention (7) du dispositif peut être positionné et détaché de façon manuelle.

2. Montage d'essai (1) selon la revendication 1, dans lequel au moins l'un de l'élément magnétique (16) de la plateforme et de l'élément magnétique (17) du couvercle comprend un aimant permanent.

3. Montage d'essai (1) selon la revendication 1 ou la revendication 2, dans lequel l'élément magnétique (16) de la plateforme et l'élément magnétique (17) du couvercle sont mutuellement alignés sur un axe normal à la plateforme d'essai (3).

4. Montage d'essai (1) selon l'une quelconque des revendications 1 à 3, dans lequel l'élément magnétique (17) du couvercle est reçu de manière amovible dans un support évidé (18).

5. Montage d'essai (1) selon l'une quelconque des revendications 1 à 4, dans lequel l'au moins un guide de positionnement de dispositif (6) comprend une tige cylindrique (6).

6. Montage d'essai (1) selon la revendication 5, dans lequel le couvercle (7) de rétention détachable du dispositif comprend au moins un évidement (10) s'adaptant à la tige cylindrique.

7. Montage d'essai (1) selon l'une quelconque des revendications 1 à 6, dans lequel la plateforme d'essai (3) comprend au moins un guide d'alignement (11) du couvercle disposé sur la surface de réception (5) du dispositif.

8. Montage d'essai (1) selon la revendication 7 dans lequel l'au moins un guide d'alignement (11) du couvercle comprend une paroi périphérique (11) alignée avec un bord externe du couvercle (7) de rétention détachable du dispositif dans une position couverte.

9. Montage d'essai (1) selon la revendication 8, dans lequel la paroi périphérique (11) comprend un bord de guidage (12) du couvercle à chanfrein rentrant.

10. Montage d'essai (1) selon l'une quelconque des revendications 1 à 9, dans lequel le couvercle (7) de rétention détachable du dispositif possède une surface en vis-à-vis de la plateforme d'essai avec un support de réception de dispositif (9).

11. Montage d'essai (1) selon l'une quelconque des revendications 1 à 10, dans lequel la plateforme d'essai (3) comprend des jambes de support (13).

12. Montage d'essai (1) selon l'une quelconque des revendications 1 à 11, comprenant en outre un logement de confinement (14).

13. Montage d'essai (1) selon la revendication 12, dans lequel le logement de confinement (14) comprend une enceinte de blocage des radiofréquences.

14. Montage d'essai (1) selon la revendication 12 ou la revendication 13, dans lequel le logement de confinement (14) possède un capot articulé (15).

15. Montage d'essai (1) selon l'une quelconque des revendications 1 à 14, comprenant deux éléments magnétiques (16) de la plateforme ou plus et deux éléments magnétiques (17) du couvercle ou plus, les éléments magnétiques (16) de la plateforme et les éléments magnétiques (17) du couvercle ayant un agencement spatial correspondant pour fixer de manière amovible le couvercle (7) de rétention détachable du dispositif à la plateforme d'essai (13).

16. Procédé de production d'un dispositif électronique, comprenant le fait :
de préparer un montage d'essai (1) selon l'une quelconque des revendications 1 à 15, destiné à l'essai du dispositif électronique ;
de placer le dispositif électronique (2) en utilisant l'au moins un guide de positionnement (6) du dispositif disposé sur la surface de réception (5) du dispositif ;
de positionner manuellement le couvercle (7) de rétention détachable du dispositif sur le dispositif électronique (2) afin d'exercer une pression de serrage sur le dispositif électronique (2).

17. Procédé selon la revendication 16, dans lequel l'étape de placement du dispositif électronique (2) sur la surface de réception (5) du dispositif est réalisée manuellement.

18. Procédé selon l'une quelconque des revendications 16 à 17, dans lequel le procédé comprend l'étape supplémentaire qui consiste à fermer un capot (15) après l'étape de placement du couvercle (7) de rétention détachable du dispositif sur le dispositif électronique (2).
